# EUROPEAN PATENT APPLICATION

(11) **EP 4 653 111 A1**
(43) Date of publication of application: **26.11.2025**
(21) Application number: 23917703.3
(22) Date of filing: 13.12.2023
(51) Int. Cl.: B22F 9/00, B22F 1/00, B22F 7/08, B23K 1/00, B23K 1/19, C22C 5/08, C22C 9/00, H01L 23/12, H05K 1/03, H05K 1/09

(54) **METHOD FOR PRODUCING ACTIVE METAL PASTE, METHOD FOR PRODUCING CERAMIC CIRCUIT BOARD, METHOD FOR PRODUCING SEMICONDUCTOR DEVICE, ACTIVE METAL PASTE, CERAMIC CIRCUIT BOARD, AND SEMICONDUCTOR DEVICE**

(30) Priority: 17.01.2023 JP 2023004797
(71) Applicant: Kabushiki Kaisha Toshiba, Tokyo 105-0023 (JP); Toshiba Materials Co., Ltd., Isogo-Ku Yokohama-Shi Kanagawa 235-0032 (JP)
(72) Inventor: YAMAMOTO, Shota, Yokohama-shi, Kanagawa 235-0032 (JP)
(74) Representative: Hoffmann Eitle
(86) International application number: PCT/JP2023/044719
(87) International publication number: WO 2024/154492

(57) **Abstract**

A method for producing an active metal paste (6) according to an embodiment includes a premixing process and a kneading process. The premixing process includes producing a mixture by mixing a binder with a metal powder; the metal powder includes copper and an active metal; the binder includes a resin dissolved in an organic solvent; and the mixture includes 60 to 95 mass% of the metal powder. The kneading process includes producing an active metal paste (6) by causing the mixture to rotate and revolve.

## Description

### [Technical Field]

Embodiments relate generally to a method for producing an active metal paste, a method for producing a ceramic circuit board, a method for producing a semiconductor device, an active metal paste, a ceramic circuit board, and a semiconductor device.

### [Background Art]

A ceramic circuit board is used in a semiconductor device in which a semiconductor element such as a power element or the like is mounted. A ceramic substrate and a metal circuit part are bonded to each other via a bonding layer using an active metal brazing material, etc. The bonding strength and heat cycle characteristics are improved thereby. As reliability is increased, ceramic circuit boards are being used in inverters of automobiles (including electric vehicles), electric railway vehicles, solar power generation equipment, industrial machinery, etc. In a semiconductor device such as a power module or the like, a semiconductor element is mounted to a circuit part. Also, wire bonding and/or bonding of a metal terminal may be performed to electrically connect the semiconductor element. The semiconductor element, the wire bonding, the metal terminal, etc., are bonded to the circuit part in the production of the semiconductor device.

A method of forming an active metal brazing material or the like as a paste and printing the active metal brazing material or the like on a ceramic substrate is discussed as a method of forming a bonding layer of a ceramic circuit board (Patent Literature 1). According to Patent Literature 1, a brazing material paste is prepared by performing a mixing process of mixing brazing material constituent component powders for not less than 10 hours, and by mixing a binder and/or solvent with the mixed powder. The mixing process of the mixed powder, the binder, and the like is performed for not less than 10 hours. The etching effect difference of a bonding layer using the paste according to Patent Literature 1 is suppressed by controlling the distribution of Ag (silver). It is stated that such control of the size of an etched jutting part of the bonding part may lead to improvement of the temperature cycle test (TCT) characteristics.

A method of performing mechanical dispersion processing of a kneaded object is discussed as a method for producing a paste. (Patent Literature 2). According to Patent Literature 2, examples of the mechanical dispersion processing include ultrasonic dispersion, a disper, a three-roll mill, a ball mill, a bead mill, a twin-screw kneader, a planetary centrifugal mixer, etc. In Patent Literature 2, ultrasonic dispersion and three-roll rolling are given as examples in the Detailed Description.

Also, a production method that uses a planetary centrifugal mixer is discussed as a method for producing a paste. (Patent Literature 3). Patent Literature 3 describes silver paste in which a silver powder, terpineol, and a resin are kneaded using a planetary centrifugal mixer with a centrifugal force of 420 G.

### [Prior Art Documents]

### [Patent Literature]

Patent Literature 1: International Publication No. 2022/085654
Patent Literature 2: International Publication No. 2012/070262
Patent Literature 3: Japanese Patent No. 5790433

### [Summary of Invention]

### [Problem to be Solved by the Invention]

With the demand for higher reliability of semiconductor substrates that use ceramic circuit boards, it has become apparent that issues occur when improving the bonding strength and heat cycle characteristics of ceramic circuit boards. To improve characteristics, brazing materials that match the purpose are used, and the brazing material components of such brazing materials must be formed as a paste by uniform and efficient mixing. Metal materials that are used in brazing materials have different powder shapes and densities according to the type. Furthermore, for metal materials, mixing with solvents and/or resin components for forming as a paste also must be taken into account. Although paste components can be uniformly mixed by increasing the mixing time, the task time also increases proportionally, which increases the cost.

Embodiments of the invention are directed to solve such problems, and to provide a method for producing an active metal paste that can be kneaded into more uniform paste while suppressing a cost increase, and methods for producing a ceramic circuit board and a semiconductor device that use the active metal paste. Embodiments of the invention also provide an active metal paste that is more uniformly kneaded, and a ceramic circuit board and a semiconductor device that use the active metal paste.

### [Means for Solving the Problem]

A method for producing an active metal paste according to an embodiment includes a premixing process and a kneading process. The premixing process includes producing a mixture by mixing a binder with a metal powder; the metal powder includes copper and an active metal; the binder includes a resin dissolved in an organic solvent; and the mixture includes 60 to 95 mass% of the metal powder. The kneading process includes producing an active metal paste by causing the mixture to rotate and revolve.

### [Brief Description of Drawings]

[FIG. 1]

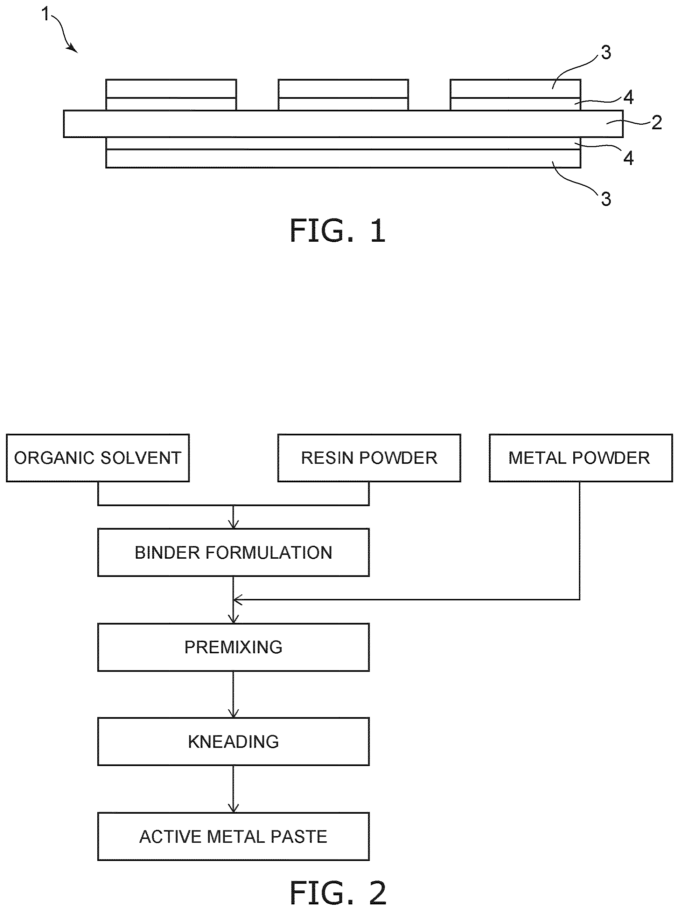

   FIG. 1 is a side view showing an example of a ceramic circuit board according to an embodiment.
[FIG. 2]
   FIG. 2 is a process flowchart showing an example of a method for producing an active metal paste according to an embodiment.
[FIG. 3]

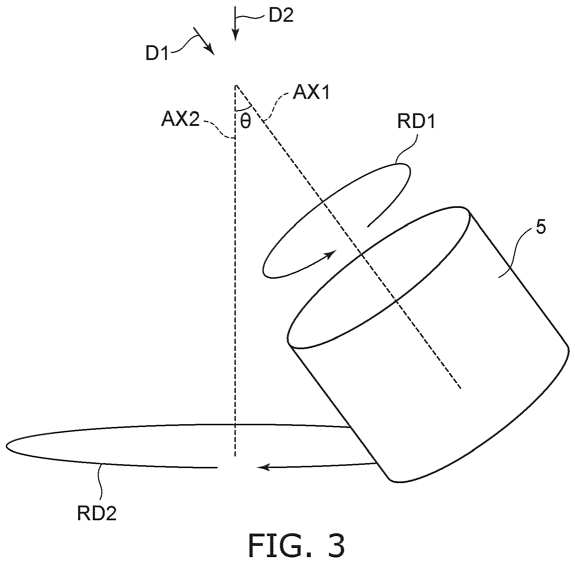

   FIG. 3 is a schematic view showing an example of kneading of the active metal paste according to the embodiment.
[FIG. 4]

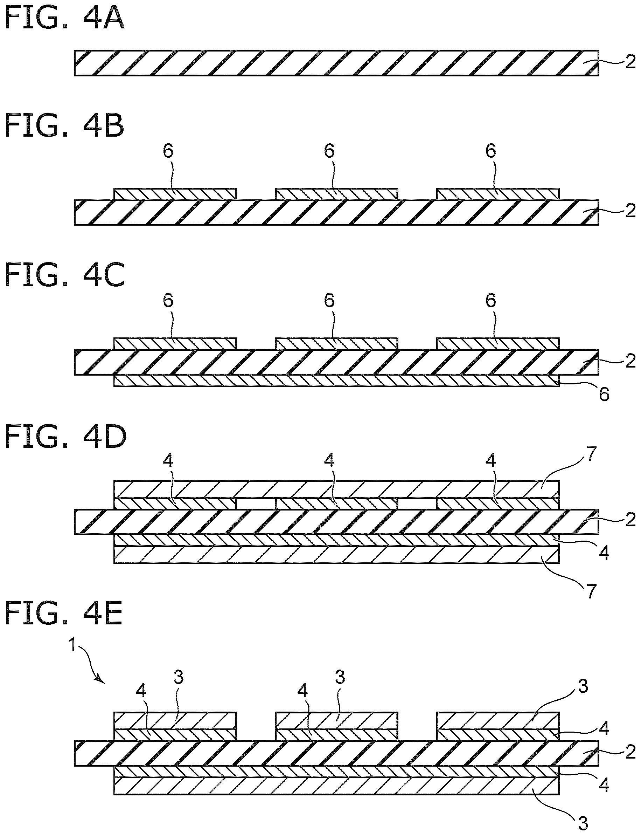

   FIG. 4 is a cross-sectional view showing an example of production processes of the ceramic circuit board according to the embodiment.
[FIG. 5]

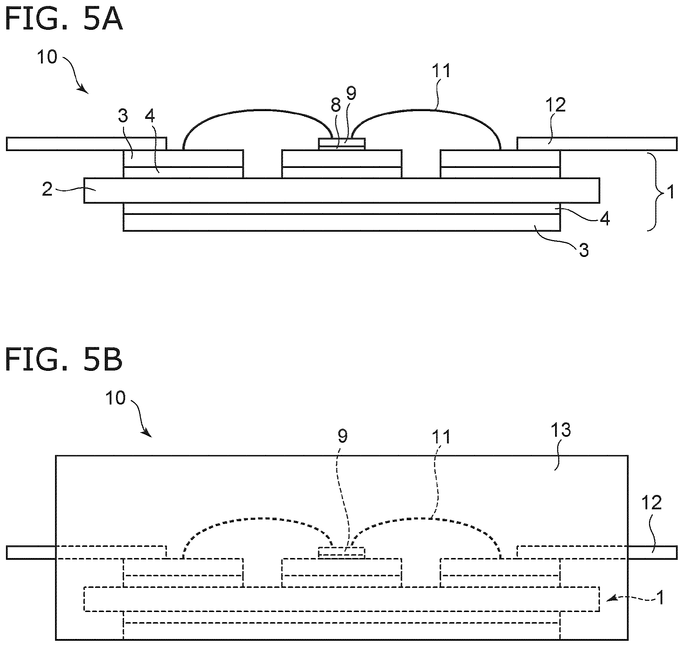

   FIG. 5 is a side view showing an example of a semiconductor device according to an embodiment.

### [Description of Embodiments]

A method for producing an active metal paste according to an embodiment is a method for producing an active metal paste that includes, in a paste, 60 to 95 mass% of a metal powder including copper and at least one active metal. The production method includes a premixing process of mixing a binder with the metal powder, wherein the binder includes a resin dissolved in an organic solvent, and a kneading process of kneading a premixed paste. Also, the kneading process includes kneading to cause the premixed paste to rotate and revolve. The active metal paste is used to manufacture a ceramic circuit board.

FIG. 1 is a cross-sectional view showing an example of a ceramic circuit board according to an embodiment. In FIG. 1, 1 is a ceramic circuit board. 2 is a ceramic substrate. 3 is a metal circuit. 4 is a bonding layer. The metal circuit 3 is bonded to the ceramic substrate 2 via the bonding layer 4. In the example of FIG. 1, three metal circuits 3 are bonded to the upper surface of the ceramic substrate 2 respectively via three bonding layers 4. One metal circuit 3 is bonded to the lower surface of the ceramic substrate 2. The metal circuit 3 at the lower surface may function as a heat dissipation plate rather than a circuit. The embodiment is not limited to the illustrated example. For example, one, two, four, or more metal circuits 3 may be bonded to the upper surface of the ceramic substrate 2.

It is favorable for the ceramic substrate 2 to be at least one of a silicon nitride substrate, an aluminum nitride substrate, or an aluminum oxide substrate. An Alusil substrate is an example of one type of aluminum oxide substrate. Alusil is a sintered body in which 20 to 80 mass% is aluminum oxide, and the remainder is zirconium oxide. The three-point bending strengths of an aluminum nitride substrate and an aluminum oxide substrate each are about 300 to 450 MPa. The strength of an Alusil substrate is about 550 MPa. The three-point bending strength of a silicon nitride substrate can be not less than 600 MPa, and can be further increased to be not less than 700 MPa. The thermal conductivity of a silicon nitride substrate is not less than 50 W/(m·K) and can be further increased to be not less than 80 W/(m·K). In particular, in recent years, there is a silicon nitride substrate that has both high strength and high thermal conductivity. Because the silicon nitride substrate has a high strength, the silicon nitride substrate can be thin; and it is possible to further improve the heat dissipation. To improve the heat dissipation, it is favorable for the thickness of the silicon nitride substrate to be not more than 0.635 mm, and more favorably not more than 0.3 mm. Although not particularly limited, it is favorable for the lower limit of the thickness to be not less than 0.1 mm. This is to ensure the electrical insulation of the silicon nitride substrate. Here, the thickness refers to the dimension of the ceramic substrate 2 in a direction connecting the upper surface and lower surface of the ceramic substrate 2. Such a ceramic substrate 2 may be a single plate, or may have a three-dimensional structure such as a multilayer structure, etc. The thickness of the ceramic substrate 2 is not particularly limited. The heat dissipation is improved by making the ceramic circuit board thinner and by making the metal circuit thicker.

The metal circuit 3 includes metals such as copper, a copper alloy, etc. Copper and copper alloys have high electrical conductivity and are favorable for electrical circuits. Also, copper and copper alloys have high thermal conductivity, and therefore have excellent heat dissipation from a semiconductor element mounted on the metal circuit 3. For example, other than impurities, etc., the metal circuit 3 is made of copper or a copper alloy.

It is favorable for the ceramic substrate 2 and the metal circuit 3 to be bonded via the bonding layer 4. It is favorable for the bonding layer 4 to include at least one selected from the group consisting of copper (Cu) and silver (Ag) and one or more active metals selected from the group consisting of titanium (Ti), zirconium (Zr), hafnium (Hf), and niobium (Nb). The bonding layer 4 may further include at least one selected from the group consisting of tin (Sn), indium (In), zinc (Zn), magnesium (Mg), and aluminum (Al). Also, the bonding layer 4 may include inorganic substances other than metals such as silicon (Si), carbon (C), etc. When the metal circuit 3 is copper or a copper alloy, it is favorable for the bonding layer 4 to include Cu and Ti.

FIG. 2 is a process flowchart showing an example of a method for producing the active metal paste according to the embodiment. The production method according to the embodiment includes a binder formulation process, a premixing process, and a kneading process.

First, an organic solvent, a resin powder, and a metal powder are prepared. The organic solvent is not particularly limited as long as the organic solvent can be burned off in a drying process and/or a bonding process. Favorable examples of organic solvents include terpineol, butyl carbitol, etc. The resin is not particularly limited as long as the resin can be burned off in the drying process and/or the bonding process. Favorable examples of the resin include ethyl cellulose, polyvinyl butyral, an acrylic resin, etc.

The metal powder includes at least one selected from Cu and Ag, and one or more active metals selected from the group consisting of Ti, Zr, Hf, and Nb. The metal powder may further include a metal component such as Sn, In, Zn, Al, Mg, etc. The metal powder may further include inorganic components such as C, Si, etc. For example, when the metal powder includes Cu and Ti, it is favorable for the metal powder to include a Cu content of not less than 50 mass%, a Ti content of not less than 4 mass% and not less than 30 mass%, a content of one or two selected from Sn or In of not less than 5 mass% and not more than 45 mass%, and a C content of not less than 0 mass% and not more than 2 mass%. When the metal powder includes Ag, Cu, and Ti, it is favorable for the metal powder to include a Ag content of not less than 20 mass% and not more than 60 mass%, a Cu content of not less than 15 mass% and not more than 40 mass%, a Ti content of not less than 1 mass% and not more than 15 mass%, and a content of one or two selected from Sn or In of not less than 5 mass% and not more than 25 mass%. At least one selected from the group consisting of Al, Si, and Mg may be added within the range of 1 to 15 mass% as necessary.

The binder formulation process includes formulating the binder by dissolving the resin in the organic solvent. Other than the resin and the organic solvent, to help dispersion and prevent agglomeration, a dispersant and/or a surfactant may be added as necessary. A commercially available binder in which a resin is dissolved in an organic solvent may be prepared, and the binder formulation process may be omitted.

Then, a premixing process of mixing the metal powder with the formulated binder is performed. The premixing includes using an agitator or a mortar machine to mix and blend the binder and the metal powder. There are cases where the metal powder remains unmixed, and so the mixing is performed so that agglomeration of the metal powder is not visible to the naked eye. The premixing process obtains a mixture in which the binder and the metal powder are mixed.

Then, a kneading process of forming the mixture as a paste is performed. The kneading process disperses the metal powder more uniformly in the mixture, and obtains a favorable paste for printing.

FIG. 3 is a schematic view showing an example of kneading of the active metal paste according to the embodiment. In FIG. 3, 5 is a kneading container into which a mixture of the binder and the metal powder is placed. The kneading container 5 rotates with an axis AX1 as the center. Also, the kneading container 5 revolves with an axis AX2 as the center. The axis AX1 is tilted with respect to the axis AX2. For example, the axis AX1 is tilted with respect to the vertical direction. The axis AX2 is parallel to the vertical direction. It is favorable for an angle θ between the axis AX1 and the axis AX2 to be not less than 25 degrees and not more than 50 degrees, and more favorably not less than 30 degrees and not more than 45 degrees. A rotational direction RD1 of the kneading container 5 when viewed along a direction D1 parallel to the axis AX1 is the opposite of a rotational direction RD2 of the kneading container 5 when viewed along a direction D2 parallel to the axis AX2. In the illustrated example, the kneading container 5 rotates leftward (the counterclockwise direction) when viewed along the direction D1. Also, the kneading container 5 revolves rightward (the clockwise direction) when viewed along the direction D2. By the kneading container 5 revolving, a force acts to move the mixture of the binder and the metal powder in the centrifugal direction; and the mixture is degassed. Also, by the kneading container 5 rotating, the mixture is stirred by convection.

To knead efficiently in the kneading process, it is desirable to divide the kneading process into steps having modified kneading conditions. The kneading process includes primary kneading, secondary kneading, and tertiary kneading. The primary kneading performs kneading by substantially only revolving. The secondary kneading performs kneading by revolving and rotating. The revolution speed of the secondary kneading is less than the revolution speed of the primary kneading. The rotation speed of the secondary kneading is less than the revolution speed of the secondary kneading. The tertiary kneading performs kneading by revolving and rotating. The revolution speed of the tertiary kneading is greater than the revolution speed of the secondary kneading. The rotation speed of the tertiary kneading is less than the revolution speed of the tertiary kneading. Although the kneading container 5 may rotate in the primary kneading, it is favorable for the rotation speed to be sufficiently less than the rotation speed of the secondary or tertiary kneading. The mixture can be efficiently kneaded by processing in stages from the primary kneading to the tertiary kneading.

In the primary kneading, the mixture is kneaded by revolving for a preset time while maintaining the revolution speed. In the secondary kneading and the tertiary kneading, the mixture is kneaded by revolving and rotating for a preset time while maintaining the revolution and rotation speeds.

The primary kneading promotes degassing of the mixture by kneading by substantially only revolving. Ambient air and the like that is trapped during production processes is present as bubbles inside the mixture. When the paste is printed with bubbles remaining in the paste, there is a possibility that defects such as voids, etc., may occur. It is therefore desirable to remove bubbles as much as possible. If stirring proceeds without sufficiently degassing, the bubbles inside the mixture become finely divided. Although the mixture may appear to be degassed and bubbles are not easily observed, fine defects are merely dispersed, which is unfavorable. To sufficiently degas, it is favorable for the centrifugal acceleration of the primary kneading to be not less than 80% of the centrifugal acceleration of the tertiary kneading. When the centrifugal acceleration is less than 80%, there is a possibility that the mixture cannot be sufficiently degassed. It is more favorable for the centrifugal acceleration of the primary kneading to be not less than 85% of the centrifugal acceleration of the tertiary kneading, and most favorably not less than 90% of the centrifugal acceleration of the tertiary kneading. On the other hand, when the centrifugal acceleration of the primary kneading is too large, there is a possibility that fine defects may be dispersed and may remain as described above. It is therefore favorable for the centrifugal acceleration of the primary kneading to be not more than 100% of the centrifugal acceleration of the tertiary kneading, and more favorably not more than 95% of the centrifugal acceleration of the tertiary kneading.

It is desirable for the time of the primary kneading to be not less than 10% of the total kneading time. When the kneading time is less than 10%, there is a possibility that the mixture cannot be sufficiently degassed. The mixture is degassed further as the time of the primary kneading increases. When, however, the time of the primary kneading causes the kneading to be longer than necessary, the total time of the kneading process lengthens, and the temperature of the mixture increases. As a result, there is a possibility that the kneading process may affect properties such as the paste viscosity, etc. It is therefore favorable for the time of the primary kneading to be not more than 20% of the total kneading time, and more favorably not more than 15%.

In the secondary kneading, the degassed mixture is stirred by rotating in addition to revolving. By intensely rotating the mixture, stirring within the metal powder and stirring of the metal powder and the binder proceed; and the metal powder is more uniformly dispersed. The secondary kneading is directed to stir the entire mixture. Therefore, in the secondary kneading, the kneading is performed by revolving at a smaller speed than that of the primary kneading, and by rotating at a smaller speed than the revolving of the secondary kneading. By setting the revolution speed to be less than that of the primary kneading, the force that moves the mixture in the centrifugal direction is suppressed. By suppressing the force of moving in the centrifugal direction, the degassing effect of the mixture is reduced, but the material flows easily. Also, by rotating at a smaller speed than the revolving, stirring of the mixture is promoted. The mixture includes the metal powder and the binder. When the stirring within the metal powder and the stirring between the metal powder and the binder is insufficiently performed, a paste in which the metal powder is uniformly dispersed in the binder is not obtained. It is therefore desirable to stir the metal powder inside the binder as much as possible. If the paste formation proceeds without sufficient stirring, there is a possibility that a paste may be obtained that includes portions that include only the binder without the metal powder, or a paste may be obtained that includes portions at which the metal components are biased, which is unfavorable.

To perform sufficient stirring, it is favorable for the centrifugal acceleration of the secondary kneading to be not less than 50% of the centrifugal acceleration of the tertiary kneading. When the centrifugal acceleration is less than 50%, there is a possibility that the metal powder may not be sufficiently stirred. It is more favorable for the centrifugal acceleration of the secondary kneading to be not less than 60% of the centrifugal acceleration of the tertiary kneading, and most favorably not less than 70% of the centrifugal acceleration of the tertiary kneading. On the other hand, when the centrifugal acceleration of the secondary kneading is too large, there is a possibility that the formation of the paste may proceed without stirring as described above. It is therefore favorable for the centrifugal acceleration of the secondary kneading to be not more than 90% of the centrifugal acceleration of the tertiary kneading, and more favorably not more than 80% of the centrifugal acceleration of the tertiary kneading.

It is desirable for the time of the secondary kneading to be not less than 10% of the total kneading time. When the kneading time is less than 10%, there is a possibility that the metal powder may not be sufficiently stirred. Although the metal powder can be stirred more as the time of the secondary kneading increases, if the time of secondary kneading is longer than necessary, the total kneading time increases, and the temperature of the mixture increases. As a result, there is a possibility that the kneading process may affect the properties of the paste viscosity, etc. It is therefore favorable for the time of the secondary kneading to be not more than 20% of the total kneading time, or even not more than 15% of the total kneading time.

In the tertiary kneading, the kneaded object of which the stirring proceeded in the secondary kneading is stirred with even more intense revolving and rotating. The mixture is stirred while applying a shear force by setting a greater revolution speed than the secondary kneading, and by setting the rotation speed to be less than the revolution speed. The paste formation of the mixture is promoted by the stirring with the shear force applied. It is favorable for the force applied to the mixture by the tertiary kneading to be greater than the force applied to the mixture by the primary kneading and greater than the force applied to the mixture by the secondary kneading. In other words, it is favorable for the centrifugal acceleration of the tertiary kneading to be greater than the centrifugal acceleration of the primary kneading and greater than the centrifugal acceleration of the secondary kneading. To make the centrifugal acceleration of the tertiary kneading greater than those of the primary and secondary kneading, it is favorable for the revolution speed of the tertiary kneading to be greater than the revolution speeds of the primary and secondary kneading, and for the rotation speed of the tertiary kneading to be greater than the rotation speeds of the primary and secondary kneading. Although it is possible to increase the centrifugal acceleration by increasing the speed of only one of the revolving or rotating of the tertiary kneading compared to the primary and secondary kneading, there is a possibility that the revolving centrifugal force or the rotating centrifugal force may become too large, and an excessive load may be applied to the apparatus or the mixture.

Although it also may be considered to omit the secondary kneading and to proceed directly from the primary kneading to the tertiary kneading, if the premixing is insufficiently performed or the stirring of the tertiary kneading is insufficient, there is a possibility that the metal powder may not be sufficiently dispersed in the paste that is made. It is therefore favorable for the kneading process to include the three steps of the primary, secondary, and tertiary kneading. As long as the kneading process includes the primary to tertiary kneading, another kneading step may be set between the primary kneading and the secondary kneading, between the secondary kneading and the tertiary kneading, or after the tertiary kneading. However, as described above, an increase of the total kneading time may cause a temperature rise of the mixture. Accordingly, when another step is set, it is favorable for the time of the other step to be short.

An active metal paste is obtained by the processes described above. The paste that is completed by the kneading is printed onto a ceramic substrate. It is favorable for the printing thickness of the paste to be 15 to 40 µm. When the printing thickness is less than 15 µm, there is a possibility that the thickness of the active metal brazing material layer may fluctuate, and the bonding strength may be reduced. On the other hand, the effects on the bonding strength are not improved when the printing thickness is greater than 40 µm, and so the cost may be increased. The paste is printed with a uniform thickness on the ceramic part end surface by screen printing, etc. When the printing thickness is nonuniform, the active metal brazing material is excessive at the thick portions, causing brazing material buildup and cracks due to thermal stress. At the thin portions, insufficient active metal brazing material results in locations of reduced strength. Therefore, for the paste after printing, it is favorable for the difference between the thickness of the thickest portion and the thickness of the thinnest portion to be not more than 10 µm, and more favorably not more than 5 µm.

FIGS. 4A to 4E are cross-sectional views showing an example of production processes of the ceramic circuit board according to the embodiment. FIG. 4A shows the ceramic substrate 2 before printing an active metal paste 6. As shown in FIG. 4B, the active metal paste 6 is printed on the upper surface of the ceramic substrate 2 and dried. In the illustrated example, the active metal paste 6 is selectively printed only in regions at which a metal circuit will be located subsequently. Then, as shown in FIG. 4C, the active metal paste 6 is printed on the lower surface of the ceramic substrate 2 and dried. As shown in FIG. 4D, a metal plate 7 is placed on the surface of the dried active metal paste 6 and bonded. The bonding layer 4 is formed by the active metal paste 6 melting and solidifying. Subsequently, as shown in FIG. 4E, the metal circuit 3 is formed by patterning the metal plate 7 into the shape of a metal circuit by etching, etc. The ceramic circuit board 1 that includes the ceramic substrate 2 and the metal circuit 3 is produced by the processes described above.

In the process shown in FIG. 4B, the active metal paste 6 may be printed on the upper surface of the ceramic substrate 2 in an area that is wider than the metal circuit 3. In such a case, a portion of the bonding layer 4 is etched after etching a portion of the metal plate 7. Also, pre-patterned metal circuits 3 may be prepared, and the metal circuits 3 may be placed on the active metal paste 6. In such a case, the etching process shown in FIG. 4D is omitted.

A metal thin film may be located at the surface of the metal circuit 3 of the ceramic circuit board 1. The metal thin film includes one selected from the group consisting of Ni (nickel), Ag (silver), and Au (gold) as a major component. Here, "major component" refers to a component of which not less than 50% is included. The metal thin film is a plating film, a sputtered film, etc. By providing the metal thin film, the corrosion resistance, the solder wettability, etc., can be improved.

FIGS. 5A and 5B are side views showing an example of a semiconductor device according to an embodiment. The ceramic circuit board 1 according to the embodiment is favorable for a semiconductor device. In the semiconductor device, a semiconductor element is mounted to the metal circuit 3 via a bonding layer. In FIG. 5A, 1 is a ceramic circuit board. 8 is a bonding layer. 9 is a semiconductor element. 10 is a semiconductor device. 11 is wire bonding. 12 is a leadframe. In FIG. 5B, 13 is a mold resin. FIG. 5B shows a state in which the semiconductor device 10 shown in FIG. 5A is covered with the mold resin 13.

As shown in FIG. 5A, the semiconductor element 9 is mounted on the metal circuit 3 of the ceramic circuit board 1 via the bonding layer 8. The wire bonding 11 conducts between the adjacent metal circuits 3. The semiconductor device 10 according to the embodiment is not limited to such a structure. For example, multiple semiconductor elements 9 and multiple wire bonding 11 may be provided at the metal circuits 3 of the upper surface. Also, a semiconductor element, wire bonding, etc., may be bonded to the metal circuit 3 of the lower surface as necessary. A metal terminal such as a leadframe, etc., may be bonded to the ceramic circuit board 1. The bonding layer 8 that bonds the semiconductor element 9 includes solder, a brazing material, etc. It is favorable for the solder to be lead-free solder. "Solder" refers to a bonding material having a melting point of not more than 450 °C. "Brazing material" refers to a bonding material having a melting point that is greater than 450 °C. A bonding material that has a melting point of not less than 500 °C is called a high-temperature brazing material. Examples of high-temperature brazing materials include a material including Ag as a major component.

While the semiconductor element 9 is becoming smaller, the heat generation amount from the semiconductor element 9 is increasing. It is therefore desirable to improve the heat dissipation of the ceramic circuit board 1 to which the semiconductor element 9 is mounted. Multiple semiconductor elements 9 may be mounted on the ceramic circuit board 1 to increase the performance of the semiconductor device 10 (the semiconductor module). When the temperature of any of the semiconductor elements 9 exceeds the intrinsic temperature of the element, the resistance undesirably changes to a negative temperature coefficient. Accordingly, a phenomenon occurs in which thermal runaway occurs in which concentrated power flows, and breakdown of the semiconductor device 10 instantaneously occurs. As a result, it is extremely effective to increase the reliability of the bond between the semiconductor element 9 and the metal circuit 3. Also, the semiconductor device 10 according to the embodiment can be used in a PCU, an IGBT, or an IPM module. PCU, IGBT, and IPM modules are used in inverters of automobiles (including electric vehicles), electric railway vehicles, industrial machinery, air conditioners, etc. Among automobiles, electric vehicles are becoming increasingly popular. The safety of the automobile can be increased as the reliability of the semiconductor device increases. This is similar for electric railway vehicles, industrial devices, etc.

A specific example of the method for producing the ceramic circuit board 1 according to the embodiment will now be described. The production method is not particularly limited as long as the ceramic circuit board 1 has the configuration described above. Here, an example of a method that obtains the ceramic circuit board 1 with a high yield is illustrated.

First, the ceramic substrate 2 and the metal plate 7 are prepared. It is favorable for the ceramic substrate 2 to be one selected from a silicon nitride substrate, an aluminum nitride substrate, and an aluminum oxide substrate. In particular, considering the heat dissipation of the entire ceramic circuit board 1, it is favorable for the ceramic substrate 2 to be a silicon nitride substrate having a thermal conductivity of not less than 50 W/(m·K), and a three-point bending strength of not less than 600 MPa. It is favorable for the metal plate 7 to be made of one selected from copper or a copper alloy. The ceramic substrate 2 that has a through-hole is prepared when the metal circuit 3 located at the upper surface of the ceramic substrate 2 and the metal circuit 3 located at the lower surface of the ceramic substrate 2 are electrically connected by the through-hole. When the through-hole is provided in the ceramic substrate 2, the through-hole may be pre-formed in the compact stage. Also, a through-hole may be provided in the ceramic substrate 2 (the ceramic sintered body). The through-hole is formed by laser patterning, cutting, etc. Examples of cutting include boring with a drill, etc.

It is favorable to bond a copper plate or a copper alloy plate to the ceramic substrate 2 by active metal bonding. In active metal bonding, an active metal brazing material in which an active metal such as Ti or the like is mixed with Cu is used. Examples of the active metal brazing material include a mixture of Ti and Cu, a mixture of Ti, Ag, and Cu, etc. For example, in a mixture of Ti and Cu, among inorganic components included in the mixture, the Cu content is not less than 50 mass%, the Ti content is not less than 4 mass% and not less than 30 mass%, the content of one or two selected from Sn or In is not less than 5 mass% and not more than 45 mass%, and the C content is not less than 0 mass% and not more than 2 mass%. "Inorganic components" refers to components other than organic components included in the organic solvent, the resin, etc., and refers to inorganic components other than metallic elements such as Ag, Cu, active metals, and the like included in the metal powder, metals such as Si, C, etc. In a mixture of Ti, Ag, and Cu, among the inorganic components included in the mixture, the Ag content is not less than 20 mass% and not more than 60 mass%, the Cu content is not less than 15 mass% and not more than 40 mass%, the Ti content is not less than 1 mass% and not more than 15 mass%, and the content of one or two selected from Sn or In is not less than 5 mass% and not more than 25 mass%. Also, at least one selected from the group consisting of Al, Si, and Mg within the range of 1 to 15 mass% may be added as necessary.

Then, the active metal brazing material is formed as a paste. A metal powder that has the metal mass ratio used in the active metal brazing material paste is prepared. When the metal powder is too fine, the metal powder agglomerates easily, and is not easily dispersed uniformly. Also, when the metal powder is too coarse, the metal components are not easily stirred with each other when melted by the bonding. Therefore, for the composition described above, it is favorable for the average particle size of the metal powder to be 1 to 5 µm. When the ratio of the metal powder in the paste is too small, and when organic components are evaporated by heating during the drying and bonding, the brazing material metal components necessary for bonding are not obtained. Also, when the ratio of the metal powder is too large, the viscosity necessary for printing as a paste is not obtained. Therefore, although the specific gravity of the entirety may change according to the content ratio of the active metal brazing material, it is favorable for the paste to include 60 to 95 mass% of the metal powder.

Then, a binder for mixing the metal powder is formulated. The binder is made by dissolving a resin component in an organic solvent. Favorable examples of the resin used in the binder formulation include ethyl cellulose. Also, favorable examples of the organic solvent include terpineol. When there is much resin and less organic solvent in the binder, the viscosity of the binder increases, and it becomes difficult for the binder to mix with the metal powder. When there is less resin and much organic solvent in the binder, the viscosity of the binder decreases, and a paste that is suited to printing is not obtained. It is therefore favorable for the amount of the resin included in the binder to be 5 to 15 mass%. Other than the resin and the organic solvent, a surfactant and/or a dispersant such as sodium lauroylsarcosine, oleic acid, etc., may be added as necessary to help dispersion and prevent agglomeration. The added amount of the dispersant or the surfactant is 0.1 to 5 mass%. When the resin does not dissolve easily in the organic solvent, stirring by an agitator or a mixer, stirring by placing in an airtight container and rotating by using a pot roller, etc., are performed so that the resin component dissolves and does not remain in the organic solvent.

In the premixing, the metal component and the binder made in the binder formulation are mixed. In the premixing, the binder and the metal powder are mixed and blended by an agitator and/or a mortar machine. There are cases where the metal powder remains without being mixed, and so the mixing is performed so that aggregates of metal powder are not visible to the naked eye. In the premixing, sufficient mixing and/or stirring are not performed, and so there is a possibility that the binder and the metal component may separate if left idle. Therefore, kneading is performed immediately after premixing.

In the kneading, the premixed mixture of the binder and the metal powder is formed as a paste. The premixed mixture is placed in a lidded airtight kneading container made by polyethylene and/or polypropylene. The mixture in the kneading container is kneaded by rotating by a planetary mixing apparatus. Examples of the planetary mixing apparatus include the SK series of Shashin Kagaku Co., Ltd., the ARE series of Thinky Corporation, etc.

In the kneading process, the mixture is degassed, the stirring is promoted, and a paste is formed. It is favorable to knead efficiently by setting rotary and revolutionary conditions suited to degassing, stirring, and paste formation and by dividing into steps such as the primary, secondary, and tertiary kneading.

In the primary kneading, degassing of the mixture is promoted by kneading by substantially only revolving. To perform sufficient degassing, it is favorable for the centrifugal acceleration of the primary kneading to be not less than 80% of the centrifugal acceleration of the tertiary kneading necessary for paste formation. It is favorable for the time of the primary kneading to be not less than 10% of the total kneading time. When the primary kneading is performed on a mixture having the metal powder and binder configuration described above, it is favorable to have a centrifugal acceleration of not less than 80 G and a kneading time of not less than 45 seconds.

The secondary kneading is performed continuously from the primary kneading without standby time. In the secondary kneading, rotating is performed in addition to revolving. As a result, the stirring of the degassed mixture is promoted by rotating. The secondary kneading is directed to stir the entire mixture, and so the kneading is performed so that the revolution speed is less than that of the primary kneading, and the rotation speed is less than the revolution speed. To perform sufficient stirring, it is favorable for the centrifugal acceleration of the secondary kneading to be not less than 50% of the centrifugal acceleration of the tertiary kneading. It is favorable for the time of the secondary kneading to be not less than 10% of the total kneading time. When the secondary kneading is performed on a mixture having the metal powder and binder configuration described above, it is favorable to have a centrifugal acceleration of not less than 65 G and a kneading time of not less than 45 seconds.

The tertiary kneading is performed continuously from the secondary kneading without standby time. In the tertiary kneading, the kneaded object that was stirred by the secondary kneading is further stirred by applying a larger revolution and a larger rotation. Stirring in which a shear force is applied to the mixture is performed by the revolution speed being greater than that of the secondary kneading and by the rotation speed being less than the revolution speed. The formation of the mixture as a paste is promoted by stirring with the shear force applied. It is favorable for the force applied to the mixture by the tertiary kneading to be greater than those of the primary and secondary kneading. In other words, it is favorable for the centrifugal acceleration of the tertiary kneading to be greater than those of the primary and secondary kneading. When the tertiary kneading is performed on a mixture having the metal powder and binder configuration described above, it is favorable to have a centrifugal acceleration of not less than 100 G and a kneading time of not less than 250 seconds.

The active metal paste that is completed by kneading is printed on a ceramic substrate. The active metal paste is printed to have a uniform thickness by screen printing, etc. It is favorable for the printing thickness of the paste to be 15 to 40 µm. When the ceramic circuit board has metal circuits located at two surfaces, the active metal paste is printed on one surface, and then the paste is dried by heating in ambient air. Subsequently, the active metal paste is printed on the other surface; and the paste is similarly dried.

Then, the active metal paste is printed, and a metal plate is placed on the dried ceramic substrate. When the metal plate is a copper plate or a copper alloy plate, the ceramic substrate and the metal plate are bonded by heating the ceramic substrate on which the metal plate is placed at 700 to 900 °C. The heating process is performed in a vacuum or a nonoxidizing atmosphere as necessary. When performed in a vacuum, it is favorable for the pressure to be not more than 1×10⁻² Pa. Examples of the nonoxidizing atmosphere include a nitrogen atmosphere, an argon atmosphere, etc. The active metal paste is melted and solidified by thermal bonding. The active metal paste functions as a bonding layer bonding the ceramic substrate and the metal plate.

When the metal plate is pre-patterned into a circuit configuration, the ceramic circuit board is obtained by bonding the patterned metal circuit to the ceramic substrate. When a metal plate that is not patterned into a circuit configuration is bonded to the ceramic substrate, a metal circuit is formed by patterning by etching, etc. Not only the metal plate but also the bonding layer may be patterned into a circuit configuration by etching.

The ceramic circuit board can be produced by the processes described above. Then, a process of bonding a semiconductor element, etc., to the ceramic circuit board is performed. The bonding layer is located at the location at which the semiconductor element is to be bonded. It is favorable for the bonding layer to include solder or a brazing material. The semiconductor element is located on the ceramic circuit board with the bonding layer interposed. Wire bonding may be provided as necessary. Multiple semiconductor elements and multiple wire bonding may be provided as necessary.

According to the embodiment of the invention, an active metal paste is obtained in which the components are dispersed more uniformly and there are few bubbles. In particular, the active metal is chemically active and has high reactivity. It is therefore desirable to disperse the active metal uniformly in the paste efficiently in a shorter period of time. According to the embodiment of the invention, the components of the metal powder, which includes the active metal, can be dispersed more uniformly in the paste in a shorter period of time by the kneading process.

According to the embodiment of the invention, an active metal paste can be produced in which the dispersibilities of elemental copper and the elemental active metal each are less than 1.0. The dispersibilities of elemental copper and the elemental active metal each being less than 1.0 means that elemental copper and the elemental active metal are sufficiently dispersed in the active metal paste. By setting the dispersibilities of elemental copper and the elemental active metal each to be less than 1.0, agglomeration is suppressed, and the fluidity of the paste is improved. It is therefore easier to print the active metal paste. Also, because particles easily penetrate between other particles, reactions proceed efficiently, and the bondability is improved.

### (Examples 1 to 12 and comparative examples 1 to 10)

The ceramic substrates shown in Table 1 were prepared. The ceramic substrates were silicon nitride substrates or aluminum nitride substrates. The thermal conductivity of the silicon nitride substrate was 90 W/(m·K), and the three-point bending strength was 650 MP. The thermal conductivity of the aluminum nitride substrate was 170 W/(m·K), and the three-point bending strength was 300 MPa. The size of the ceramic substrate was 30 mm long×50 mm wide. The thickness of the silicon nitride substrate was 0.32 mm, and the thickness of the aluminum nitride substrate was 0.635 mm. In Table 1, the silicon nitride substrates were listed as Si₃N₄; and the aluminum nitride substrates were listed as AlN.

Then, the metal powders which were the metal components of the pastes shown in Table 1 were prepared. The metal powders were a silver-based powder (Ag-Cu-Sn-Ti) or a copper-based powder (Cu-Sn-TiH). The ratios of the metal components of the silver-based powder were 58 mass% Ag, 30 mass% Cu, 10 mass% Sn, and 2 mass% Ti. The ratios of the metal components of the copper-based powder were 68 mass% Cu, 20 mass% Sn, and 12 mass% TiH. The average particle size of the Ag powder was 2 µm. The average particle size of the Cu powder was 1 µm. The average particle size of the Sn powder was 5 µm. The average particle size of the Ti powder was 5 µm. The average particle size of the TiH powder was 6 µm.

Then, the binder was formulated. The binder was formulated by placing 7 mass% ethyl cellulose, 3 mass% sarcosinate, and 90 mass% terpineol in a lidded wide-mouthed bottle made of polyethylene, and by rotating with a pot roller for 24 hours.

Then, premixing was performed in which the metal powder and the binder were mixed. 20 mass% of the binder relative to 100 mass% of the total of the metal powder was placed in a cylindrical container made of polyethylene. The mixing blades were fixed to the cylindrical container opening in a perpendicular direction; and a mixture of the metal powder and the binder was made by premixing by rotating the cylindrical container for 3 minutes at 50 rpm.

Then, the mixture was formed as a paste by kneading the premixed mixture of the binder and the metal powder. An airtight lid was attached to a cylindrical container made of polyethylene in which the premixed mixture was placed; and the primary kneading, the secondary kneading, and the tertiary kneading were performed by a kneading apparatus. SK-3000 made by Shashin Kagaku was used as the kneading apparatus. The kneading conditions of the rotation speed (rpm), the revolution speed (rpm), the centrifugal acceleration (G), and the kneading time (seconds) of the steps are shown in Table 1 and Table 2.

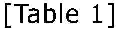

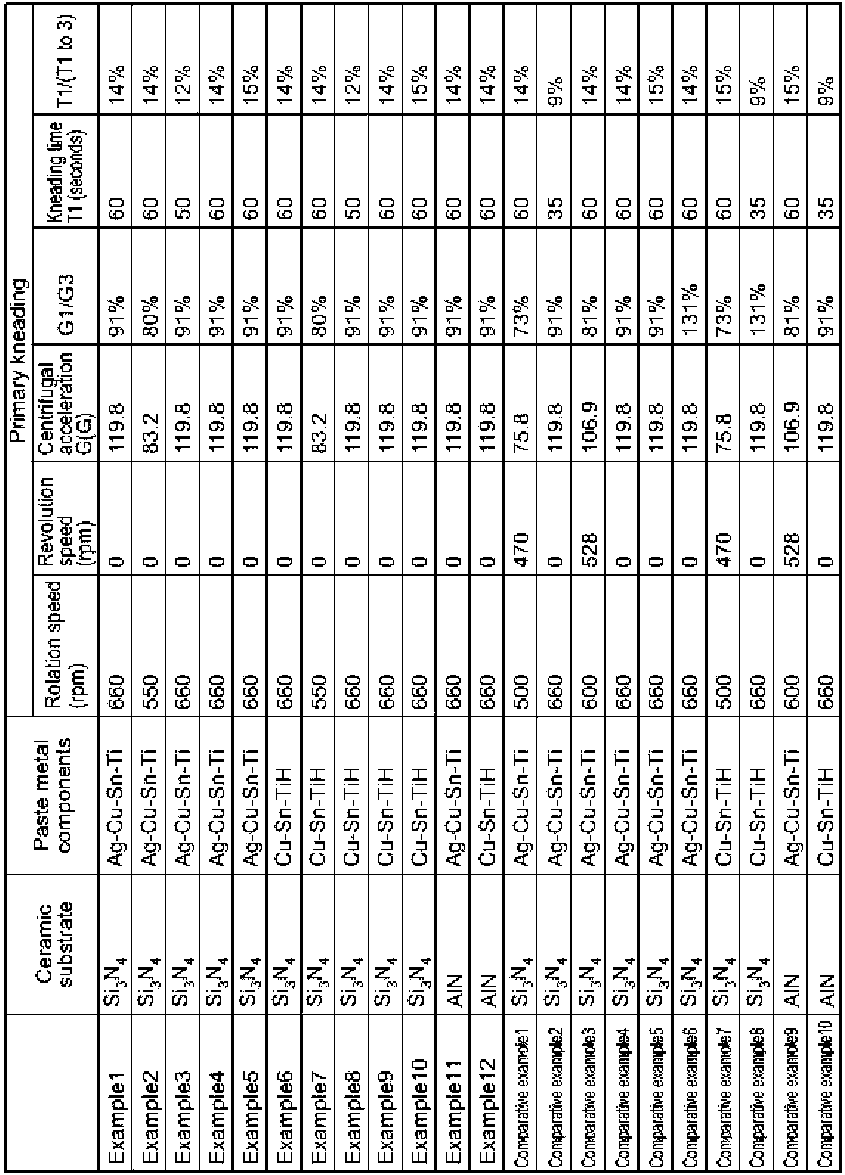

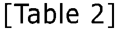

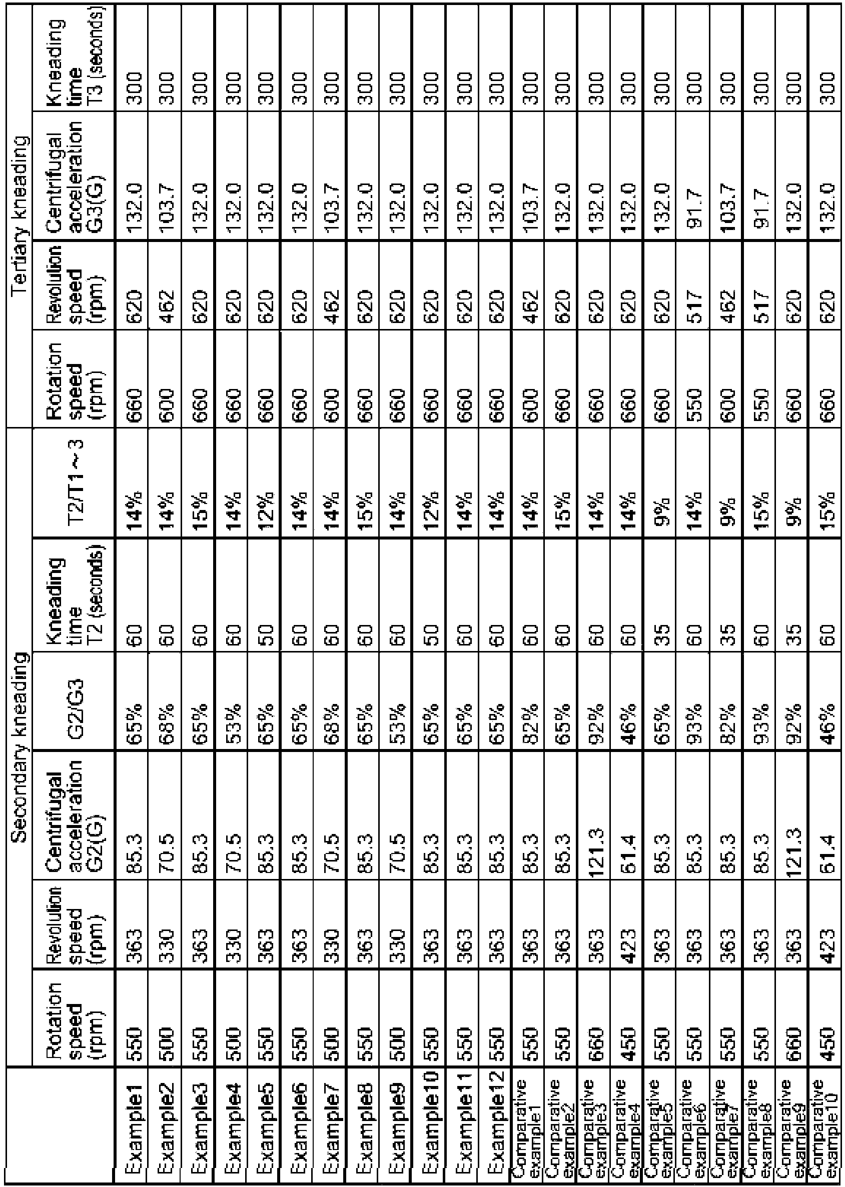

Table 1 shows the ratio (*G1*/*G3*) of the centrifugal acceleration (*G1*) of the primary kneading to the centrifugal acceleration (*G3*) of the tertiary kneading, the ratio (*T1*/*(T1* to *3)*) of the primary kneading time (*T1*) to the total kneading time ((*T1* to *3*) *= T1 + T2 + T3*)*.* Table 2 shows the ratio (*G2*/*G3*) of the centrifugal acceleration (*G2*) of the secondary kneading to the centrifugal acceleration (*G3*) of the tertiary kneading and the ratio (*T2*/(*T1* to *3*)) of the secondary kneading time (*T2*) to the total kneading time (*T1* to *3*).

The ratio (*G1*/*G3*) of the centrifugal acceleration of the primary kneading to the centrifugal acceleration of the tertiary kneading and the ratio (*T1*/(*T1* to 3)) of the primary kneading time to the total kneading time were within the favorable ranges for the kneading conditions of the pastes of the examples 1 to 12. The ratio (*G2*/*G3*) of the centrifugal acceleration of the secondary kneading to the centrifugal acceleration of the tertiary kneading and the ratio (*T2*/(*T1* to *3*)) of the secondary kneading time to the total kneading time were within the favorable ranges. On the other hand, these values were outside the favorable ranges for the comparative examples 1 to 10.

Then, the maximum agglomerated particle size was measured using a grind gauge to check the cohesion of the metal powder in the paste. The grind gauge was a block gauge made of metal with a groove having a tilted bottom surface carved in the surface of the block gauge. The depth of the groove at one end was zero. The maximum agglomerated particle size was simply measured by placing the paste in a portion at the deep side of the groove and by pulling the paste with a metallic squeegee from the deep side to the shallow side. The paste was taken to have no large agglomeration when the maximum agglomerated particle size measured using the grind gauge was less than 10 µm. In Table 3, the examples of which the measured maximum agglomerated particle sizes were less than 10 µm are listed as "OK"; and the examples of which the measured maximum agglomerated particle sizes were not less than 10 µm are listed as "NG".

The active metal paste that was completed by kneading was printed on a ceramic substrate. The active metal paste was printed using a screen plate having a size of 320 mm×320 mm and a mesh size of 200 µm. First, the three rectangular circuit configurations were printed on one surface (the upper surface) of the ceramic substrate. The active metal paste that was printed on the one surface was dried by heating for 1 minute at 100 °C in ambient air. Subsequently, one rectangular circuit configuration was printed on the other one surface (the lower surface). The active metal paste that was printed on the other one surface was dried by heating for 1 minute at 100 °C in ambient air.

Then, to check the dispersion of the metal powder inside the paste after printing and drying, the dispersibility of the Cu particles and the dispersibility of the active metal particles were evaluated. Paste was printed and dried on a polyethylene terephthalate (PET) film by using the same conditions as the ceramic substrate. A flat surface of the paste at the film side was observed using an energy dispersive X-ray analysis apparatus (SEM-EDX). S-5500 made by Hitachi High-Technologies Corporation or an equivalent apparatus was used for SEM-EDX. The size of the observation region was set to 100 µm×80 µm. Mapping data of elemental Cu and mapping data of the elemental active metal present in the observation region were acquired. The particle size distribution was calculated using particle size analysis software based on the mapping data of the elemental Cu. In other words, Voronoi tesselation of the mapping data of the elemental Cu was performed. The area distribution after partitioning was measured, and the average value and standard deviation of the areas were calculated. The value of the standard deviation divided by the average value was calculated as the dispersibility (standard deviation/average value). Similarly, for the elemental active metal as well, the particle size distribution was calculated using particle size analysis software based on the mapping data of the elemental active metal. The area distribution after partitioning was measured, and the average value and standard deviation of the areas were calculated. The value of the standard deviation divided by the average value was calculated as the dispersibility (standard deviation/average value). ImageJ can be used as the particle size analysis software.

Then, oxygen-free copper plates that were 30 mm long×50 mm wide×0.8 mm thick were placed respectively on two surfaces of the ceramic substrate on which the paste was printed and dried, and then thermal bonding was performed. When silver-based paste (Ag-Cu-Sn-Ti) was used, the bonding temperature was set to 820 °C. When copper-based paste (Cu-Sn-TiH) was used, the bonding temperature was set to 600 °C. The bonding time of each was set to 10 minutes; and bonding was performed in a vacuum (not more than 1×10⁻² Pa).

Then, the oxygen-free copper plate to which the ceramic substrate was bonded was patterned by etching. Patterning by etching was performed to form metal circuits respectively at three locations at the front surface of the ceramic substrate, and to form a metal circuit at one location at the back surface. For the circuit configurations at the three locations at the front surface, pullback of 5 mm from the ceramic substrate periphery was formed, and 5 mm non-circuit portions also were formed between the circuit configurations. Pullback of 5 mm from the ceramic substrate periphery was formed in the circuit configuration at the back surface.

Then, to check micro bondability between the metal circuit and the ceramic substrate due to the paste, voids of the bonding layer of the front surface circuit were measured by ultrasonic flaw detection (SAT: Scanning Acoustic Tomograph). Bonding layers in which defects having diameters of not less than 1 mm were observed were determined to be void defects. In Table 3, bonding layers not determined to be void defects were listed as "OK", and bonding layers determined to be void defects were listed as "NG".

Then, to check the macro bondability between the metal circuit and the ceramic substrate due to the paste, the peel strength was measured as the bonding strength between the metal circuit and the ceramic substrate. The peel strength was measured by fixing the ceramic circuit board in a jig and peeling a portion of the upper surface metal circuit in the perpendicular direction at 50 mm/min. The measurement results are shown in Table 3.

**[Table 3]**

| | Agglomeration | Dispersibility | Voids | Bonding strength (kN/m) |
|---|---|---|---|---|
| Example1 | OK | 0.79 | OK | 30 |
| Example2 | OK | 0.92 | OK | 25 |
| Example3 | OK | 0.87 | OK | 24 |
| Example4 | OK | 0.87 | OK | 26 |
| Example5 | OK | 0.89 | OK | 27 |
| Example6 | OK | 0.88 | OK | 28 |
| Example7 | OK | 0.97 | OK | 21 |
| Example8 | OK | 0.92 | OK | 23 |
| Example9 | OK | 0.93 | OK | 22 |
| Example10 | OK | 0.92 | OK | 22 |
| Example11 | OK | 0.79 | OK | 18 |
| Example12 | OK | 0.88 | OK | 17 |
| Comparative example1 | OK | 1.19 | NG | 14 |
| Comparative example2 | OK | 1.10 | NG | 16 |
| Comparative example3 | NG | 1.07 | OK | 17 |
| Comparative example4 | NG | 1.08 | OK | 16 |
| Comparative example5 | NG | 1.10 | OK | 17 |
| Comparative example4 | OK | 1.25 | OK | 13 |
| Comparative example7 | OK | 1.05 | NG | 18 |
| Comparative example4 | OK | 1.30 | NG | 13 |
| Comparative example9 | NG | 1.06 | OK | 14 |
| Comparative example10 | NG | 1.28 | NG | 13 |

For the paste according to the examples 1 to 12, there were no agglomeration defects; and the dispersibility values were within the favorable ranges. It is considered that this was because the occurrence of bubbles, agglomeration, etc., inside the paste was suppressed by setting the kneading condition of the paste to be within the favorable ranges. In contrast, for the comparative examples 1 to 10, there were cases when agglomeration defects were observed, and the dispersibility values were outside the favorable ranges. It is considered that this was because the paste remained without eliminating bubbles, agglomeration, etc.

Also, for the ceramic circuit boards in the examples 1 to 12, there were no void defects; and the bonding strength values were within the favorable ranges. It is considered that this was because the ceramic and the metal circuit were bonded using a paste having less bubbles and/or agglomeration. In contrast, for the comparative examples 1 to 10, there were cases where void defects were observed, and the bonding strength values were outside the favorable range. It is considered that this was because the bonding defects increased due to the ceramic and the metal circuit being bonded using a paste having more bubbles and/or agglomeration.

Thus, the ceramic circuit boards according to the examples are optimal for semiconductor devices in which semiconductor elements are mounted due to fewer bonding defects and a high bonding strength.

Embodiments of the invention include the following features.

### Feature 1

A method for producing an active metal paste, comprising:
a premixing process of producing a mixture by mixing a binder with a metal powder, the metal powder including copper and an active metal, the binder including a resin dissolved in an organic solvent, the mixture including 60 to 95 mass% of the metal powder; and
a kneading process of producing the active metal paste by rotating and revolving the mixture.

### Feature 2

The method for producing the active metal paste according to Feature 1, wherein
the kneading process includes:
   a primary kneading of kneading by revolving;
   a secondary kneading of kneading by revolving and rotating after the primary kneading; and
   a tertiary kneading of kneading by revolving and rotating after the secondary kneading,
a speed of the revolving of the secondary kneading is less than a speed of the revolving of the primary kneading,
a speed of the rotating of the secondary kneading is less than the speed of the revolving of the secondary kneading,
a speed of the revolving of the tertiary kneading is greater than the speed of the revolving of the secondary kneading, and
a speed of the rotating of the tertiary kneading is less than the speed of the revolving of the tertiary kneading.

### Feature 3

The method for producing the active metal paste according to Feature 2, wherein
in the kneading process, a centrifugal acceleration of the primary kneading is not less than 80% of a centrifugal acceleration of the tertiary kneading, and a centrifugal acceleration of the secondary kneading is not less than 50% of the centrifugal acceleration of the tertiary kneading.

### Feature 4

The method for producing the active metal paste according to Feature 2 or Feature 3, wherein
in the kneading process, a time of the primary kneading and a time of the secondary kneading each are not less than 10% of a total kneading time of the kneading process.

### Feature 5

A method for producing a ceramic circuit board, comprising:
performing the method for producing the active metal paste according to any one of Features 1 to 4; and
a bonding process of bonding a metal member to a ceramic substrate via the active metal paste.

### Feature 6

A method for producing a semiconductor device, comprising:
performing the method for producing the active metal paste according to any one of Features 1 to 4;
a bonding process of bonding a metal member to a ceramic substrate via the active metal paste; and
a mounting process of mounting a semiconductor element to the metal member,
a circuit being formed in the metal member.

### Feature 7

An active metal paste, comprising:
copper and at least one active metal,
dispersibilities of elemental copper and an elemental active metal in the active metal paste each being less than 1.0.

### Feature 8

The active metal paste according to Feature 7, wherein
among inorganic components, a copper content is not less than 50 mass%, an active metal content is not less than 4 mass% and not more than 30 mass%, a content of one or two selected from tin or indium is not less than 5 mass% and not more than 45 mass%, and a carbon content is not less than 0 mass% and not more than 2 mass%.

### Feature 9

The active metal paste according to Feature 7, wherein
among inorganic components, a silver content is not less than 20 mass% and not more than 60 mass%, a copper content is not less than 15 mass% and not more than 40 mass%, an active metal content is not less than 1 mass% and not more than 15 mass%, and a content of one or two selected from tin or indium is not less than 5 mass% and not more than 25 mass%.

### Feature 10

A ceramic circuit board, comprising:
a ceramic substrate; and
a metal circuit bonded with the ceramic substrate via a bonding layer made of the active metal paste according to any one of Features 7 to 9.

### Feature 11

The ceramic circuit board according to Feature 10, wherein
the ceramic substrate is one of an aluminum oxide substrate, an aluminum nitride substrate, or a silicon nitride substrate.

### Feature 12

The ceramic circuit board according to Feature 11, wherein
the metal circuit is made of copper or a copper alloy.

### Feature 13

A semiconductor device, comprising:
the ceramic circuit board according to any one of Features 10 to 12; and
a semiconductor element mounted to the metal circuit via a bonding layer.

While certain embodiments of the inventions have been illustrated, these embodiments have been presented by way of example only, and are not intended to limit the scope of the inventions. These novel embodiments may be embodied in a variety of other forms; and various omissions, substitutions, modifications, etc., can be made without departing from the spirit of the inventions. These embodiments and their modifications are within the scope and spirit of the inventions, and are within the scope of the inventions described in the claims and their equivalents. Also, the embodiments above can be implemented in combination with each other.

### [Reference Numeral List]

1 ceramic circuit board
2 ceramic substrate
3 metal circuit
4 bonding layer
5 kneading container
6 active metal paste
7 metal plate
8 bonding layer
9 semiconductor element
10 semiconductor device
11 wire bonding
12 leadframe
13 mold resin

## Claims

1. A method for producing an active metal paste (6), the method comprising:
a premixing process of producing a mixture by mixing a binder with a metal powder, the metal powder including copper and an active metal, the binder including a resin dissolved in an organic solvent, the mixture including 60 to 95 mass% of the metal powder; and
a kneading process of producing the active metal paste (6) by rotating and revolving the mixture.

2. The method for producing the active metal paste (6) according to claim 1, wherein
the kneading process includes:
a primary kneading of kneading by revolving;
a secondary kneading of kneading by revolving and rotating after the primary kneading; and
a tertiary kneading of kneading by revolving and rotating after the secondary kneading,
a speed of the revolving of the secondary kneading is less than a speed of the revolving of the primary kneading,
a speed of the rotating of the secondary kneading is less than the speed of the revolving of the secondary kneading,
a speed of the revolving of the tertiary kneading is greater than the speed of the revolving of the secondary kneading, and
a speed of the rotating of the tertiary kneading is less than the speed of the revolving of the tertiary kneading.

3. The method for producing the active metal paste (6) according to claim 2, wherein
in the kneading process, a centrifugal acceleration of the primary kneading is not less than 80% of a centrifugal acceleration of the tertiary kneading, and a centrifugal acceleration of the secondary kneading is not less than 50% of the centrifugal acceleration of the tertiary kneading.

4. The method for producing the active metal paste (6) according to claim 2, wherein
in the kneading process, a time of the primary kneading and a time of the secondary kneading each are not less than 10% of a total kneading time of the kneading process.

5. A method for producing a ceramic circuit board (1), the method comprising:
performing the method for producing the active metal paste (6) according to any one of claims 1 to 4; and
a bonding process of bonding a metal member to a ceramic substrate (2) via the active metal paste (6).

6. A method for producing a semiconductor device (10), the method comprising:
performing the method for producing the active metal paste (6) according to any one of claims 1 to 4;
a bonding process of bonding a metal member to a ceramic substrate (2) via the active metal paste (6); and
a mounting process of mounting a semiconductor element (9) to the metal member,
a circuit being formed in the metal member.

7. An active metal paste (6), comprising:
copper and at least one active metal,
dispersibilities of elemental copper and an elemental active metal in the active metal paste (6) each being less than 1.0.

8. The active metal paste (6) according to claim 7, wherein
among inorganic components, a copper content is not less than 50 mass%, an active metal content is not less than 4 mass% and not more than 30 mass%, a content of one or two selected from tin or indium is not less than 5 mass% and not more than 45 mass%, and a carbon content is not less than 0 mass% and not more than 2 mass%.

9. The active metal paste (6) according to claim 7, wherein
among inorganic components, a silver content is not less than 20 mass% and not more than 60 mass%, a copper content is not less than 15 mass% and not more than 40 mass%, an active metal content is not less than 1 mass% and not more than 15 mass%, and a content of one or two selected from tin or indium is not less than 5 mass% and not more than 25 mass%.

10. A ceramic circuit board (1), comprising:
a ceramic substrate (2); and
a metal circuit (3) bonded with the ceramic substrate (2) via a bonding layer (4) made of the active metal paste (6) according to any one of claims 8 to 9.

11. The ceramic circuit board (1) according to claim 10, wherein
the ceramic substrate (2) is one of an aluminum oxide substrate, an aluminum nitride substrate, or a silicon nitride substrate.

12. The ceramic circuit board (1) according to claim 11, wherein
the metal circuit (3) is made of copper or a copper alloy.

13. A semiconductor device (10), comprising:
the ceramic circuit board (1) according to claim 12; and
a semiconductor element (9) mounted to the metal circuit (3) via a bonding layer (8).
